(19) **Europäisches Patentamt European Patent Office Office européen des brevets**

(11) **EP 2 394 366 B1**

(12) **FASCICULE DE BREVET EUROPEEN**

(45) Date de publication et mention
de la délivrance du brevet:
**14.11.2012 Bulletin 2012/46**

(51) Int Cl.:
***H03M 13/11*** (2006.01)

(21) Numéro de dépôt: **10702296.4**

(86) Numéro de dépôt international:
**PCT/EP2010/051192**

(22) Date de dépôt: **01.02.2010**

(87) Numéro de publication internationale:
**WO 2010/089282 (12.08.2010 Gazette 2010/32)**

(54) **PROCEDE DE CODAGE CORRECTEUR D'ERREURS AVEC BITS DE PARITE TOTALE**

FEHLERKORREKTUR-CODIERUNGSVERFAHREN MIT TOTALPARITÄTBIT

ERROR-CORRECTING ENCODING METHOD WITH TOTAL PARITY BITS

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **03.02.2009 FR 0900448**

(43) Date de publication de la demande:
**14.12.2011 Bulletin 2011/50**

(73) Titulaire: **Commissariat à l'Énergie Atomique et aux Énergies Alternatives
75015 Paris (FR)**

(72) Inventeurs:
 • **GHERMAN, Valentin
 F-91300 Massy (FR)**
 • **EVAIN, Samuel
 F-91191 Gif Sur Yvette (FR)**

(74) Mandataire: **Brunelli, Gérald et al
Marks & Clerk France
Immeuble Visium
22, avenue Aristide Briand
94117 Arcueil Cedex (FR)**

(56) Documents cités:
 **EP-A1- 1 300 952      EP-A1- 1 300 953
 FR-A1- 2 823 035      FR-A5- 2 074 917
 US-A1- 2005 149 833**

 • PENZO L ET AL: "Construction techniques for systematic SEC-DED codes with single byte error detection and partial correction capability for computer memory systems" IEEE TRANSACTIONS ON INFORMATION THEORY USA, vol. 41, no. 2, mars 1995 (1995-03), pages 584-591, XP002558728 ISSN: 0018-9448
 • GHOSH S ET AL: "Reducing power consumption in memory ECC checkers" PROCEEDINGS. INTERNATIONAL TEST CONFERENCE 2004 (IEEE CAT. NO.04CH37586) IEEE PISCATAWAY, NJ, USA, 2004, pages 1322-1331, XP002558727 ISBN: 0-7803-8580-2
 • KANEDA S ED - INSTITUTE OF ELECTRICAL AND ELECTRONICS ENGINEERS: "A CLASS OF ODD-WEIGHT-COLUMN SEC-DED-SBED CODES FOR MEMORY SYSTEM APPLICATIONS" INTERNATIONAL SYMPOSIUM ON FAULT TOLERANT COMPUTING SYSTEMS. (FTCS). KISSIMMEE, FLORIDA, JUNE 20 - 22, 1984; [INTERNATIONAL SYMPOSIUM ON FAULT TOLERANT COMPUTING SYSTEMS. (FTCS)], SILVER SPRING, IEEE COMP. SOC. PRESS, US, vol. SYMP. 14, 1 juin 1984 (1984-06-01), pages 88-93, XP000746155

**Description**

L'invention concerne un procédé de codage correcteur d'erreurs avec bits de parité totale. Elle s'applique notamment aux domaines de l'électronique numérique et des télécommunications. L'invention peut être utilisée, par exemples, dans des systèmes numériques équipés d'une mémoire ou dans des systèmes d'interconnexion.

En électronique numérique, les données, appelées également informations ou messages, sont enregistrées et transmises sous forme de valeurs binaires sur des bits. Pendant le stockage ou la transmission, ces valeurs peuvent être altérées.

Pour maintenir le niveau d'intégrité des données ou pour augmenter le rendement de production, certains systèmes électroniques utilisent des Codes Correcteurs d'Erreur, désignés par l'acronyme ECC venant de l'expression anglo-saxonne « Error Correcting Code ». Dans un circuit électronique, les erreurs apparaissant sur les données peuvent être temporaires ou permanentes. Les erreurs temporaires sont produites par des interférences avec l'environnement ou sont générées par la radioactivité de certaines impuretés dans le matériau des circuits électroniques. Les erreurs permanentes sont dues à des défauts de la structure physique du circuit survenues lors de la production ou suite au vieillissement du circuit.

Dans les systèmes utilisant une protection ECC, les données sont encodées. L'opération d'encodage, appelée aussi opération de codage, mène à des mots de code contenant lesdites données auxquelles sont ajoutées des bits de vérification calculés selon un matrice choisie pour ce codage. Cette matrice est appelée habituellement matrice de parité.

Dans un second temps le mot codé est décodé pour produire la donnée originale. Pour cela un vecteur de vérification appelé syndrome est calculé. Ce dernier est utilisé pour détecter et corriger des erreurs potentielles apparaissant sur un mot de code donné. Si aucune erreur n'est détectée, le mot codé est considéré correct. Si une erreur pouvant être corrigée est détectée, le mot codé est corrigé. Enfin, si une erreur incorrigible est détectée, celle-ci est indiquée.

Pour le stockage ou la transmission de données, des codes ayant une capacité SECDED, acronyme venant de l'expression anglo-saxonne « Single Error Correction, Double Error Detection », sont habituellement utilisés. Comme leur nom l'indique, ces codes sont capables de corriger une erreur et de détecter une erreur multiple impactant deux bits d'un mot de code. Une erreur multiple désigne, dans la suite de la description, une erreur sur plusieurs bits d'un même mot de code. Les codes permettant la correction d'erreurs multiples sont très couteux en terme de calcul et sont rarement utilisés pour, par exemple, fiabiliser le stockage de données.

L'utilisation d'un code SECDED implique plusieurs types d'opérations, notamment des opérations de calcul, de contrôle, de manipulation et de stockage. La mise en oeuvre de tels codes est par conséquent consommatrice en surface de circuit, en énergie/puissance électrique et en performances de calcul. Il est donc nécessaire de disposer de codes correcteurs d'erreur performants et de dispositifs de codage et de décodage adaptés.

Un but de l'invention est notamment de pallier les inconvénients précités.

A cet effet l'invention a pour objets un procédé de codage correcteur d'erreur générant des mots de code de m bits à partir de blocs de données utiles de n bits, ledit procédé ajoutant k bits de vérification à un bloc n bits de données utiles afin de générer un mot de code de m = n + k bits, lesdits bits de vérification étant définis en suivant les règles de combinaison définies par une matrice de parité H composée d'éléments binaires et comportant k lignes et m colonnes tels que H.V = 0, V étant une matrice colonne dont les m éléments sont les m bits du mot de code à générer. Les k bits de vérification sont séparés en deux groupes, d'une part un groupe de k1 bits appelés bits de parité totale PT et d'autre part un groupe de k2 bits appelés bits de vérification classiques VC, les valeurs de k, k1 et k2 vérifiant les conditions k = k1 + k2 et k > k1 > 2. La matrice H dont les colonnes sont aptes à être permutées est décomposée en 6 sous-matrices A, B, C, D, E et F.

La sous-matrice A est une matrice carrée composée des éléments binaires à l'intersection des k1 premières colonnes et des k1 premières lignes de la matrice H, la sous-matrice A étant une matrice unité.

La sous-matrice B est composée des éléments binaires à l'intersection des colonnes k1+1 à k1+k2 et des k1 premières lignes de la matrice H et comprend un nombre impair de 1 par colonne.

La sous-matrice C est composée des éléments binaires à l'intersection des n dernières colonnes et des k1 premières lignes de la matrice H et comprend un nombre impair de 1 par colonne.

La sous-matrice D est composée des éléments binaires à l'intersection des k1 premières colonnes et des k2 dernières lignes de la matrice H et est une matrice nulle.

La sous-matrice E est une matrice carrée composée des éléments binaires à l'intersection des colonnes k1+1 à k1+k2 et des k2 dernières lignes de la matrice H et est une matrice unité.

La sous-matrice F est composée des éléments binaires à l'intersection des n dernières colonnes et des k2 dernières lignes de la matrice H telle que les colonnes de la matrice H sont différentes.

Selon un aspect de l'invention, la matrice résultant de la réunion des trois sous-matrices A, B, C de la matrice de parité H et appelée sous-matrice de parité est construite telle que chaque colonne comprend un 1.

Selon un autre aspect de l'invention, les colonnes de la matrice H de parité du code sont permutées de manière à ce qu'un mot de code généré par le procédé selon l'invention soit composé de plusieurs sous-ensembles contigus de bits, chaque sous-ensemble de bits comprenant au moins un des bits de parité totale PT.

Le document E P -A- 1 300 952 décrit un procédé semblable mais avec $k_1 = 1$ ou $R_1 = 2$.

D'autres caractéristiques et avantages de l'invention apparaîtront à l'aide de la description qui suit, donnée à titre illustratif et non limitatif, faite en regard des dessins annexés parmi lesquels :

- la figure 1 donne un exemple de mot de code et introduit les notations associées ;
- la figure 2 donne un exemple de matrice de parité pour un code de Hamming étendu ;
- la figure 3 donne un exemple de matrice de parité pour un code de Hsiao ;
- la figure 4 illustre les caractéristiques des matrices de parité représentatives du procédé de codage selon l'invention ;
- la figure 5 donne un exemple de matrice de parité d'un code BPT ;
- la figure 6 présente une matrice de parité correspondant à un exemple de code BPTC à 2 bits de parité totale complémentaires ;
- la figure 7 présente une matrice de parité correspondant à un exemple de code BPTC à 2 bits de parité totale complémentaires et dont les bits d'un mot de code sont dissociables en deux sous-ensembles ;
- la figure 8 donne un exemple de séparation d'un mot de code généré par le procédé selon l'invention en deux sous-ensembles ;
- la figure 9 donne un exemple de protocole permettant d'exploiter la propriété de séparation en sous-ensembles d'un mot de code généré par le procédé selon l'invention ;
- la figure 10 présente un exemple de matrice de parité d'un code BPTC à 3 bits de parité totale complémentaires ;
- la figure 11 présente un exemple de matrice de parité d'un code BPTC à 4 bits de parité totale complémentaires ;
- la figure 12 illustre un exemple d'algorithme de détection d'erreur multiple.

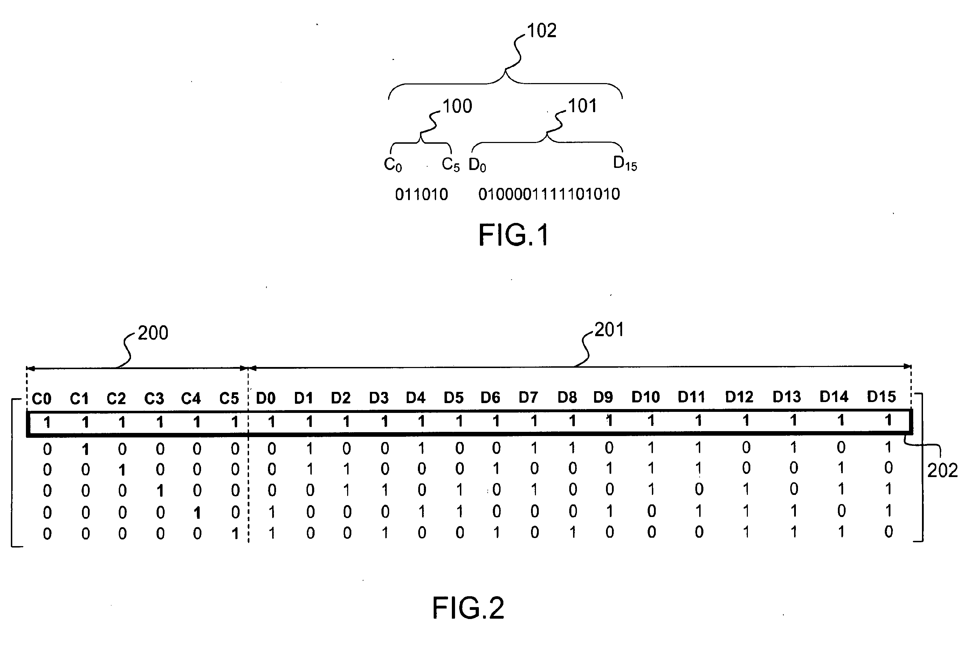

La figure 1 donne un exemple de mot de code et introduit les notations associées. Les codes SECDED sont des codes séparables, c'est-à-dire dans lesquelles les bits de vérification 100 sont ajoutés aux bits d'information 101. Ces bits de vérification permettent de détecter et/ou de corriger d'éventuels bits erronés dudit mot de code. Comme explicité précédemment, ces bits erronés peuvent apparaître à cause de perturbations survenant notamment pendant la transmission du mot de code ou durant son stockage. Dans l'exemple de la figure, 6 bits de vérification 100 notés C0 à C5 sont ajoutés à 16 bits d'information 101 notés D0 à D15. L'ensemble composé des bits d'information et des bits de vérification forment un mot de code 102. Dans le cadre de cet exemple, le mot de code comprend 22 bits.

La figure 2 donne un exemple de matrice de parité pour un code de Hamming étendu. Les codes SECDED assurent la détection d'erreurs doubles en imposant une parité totale fixe au mot codé. Les codes de Hamming étendus ainsi que le code de Hsiao sont les codes SECDED les plus communément utilisés. Ceux sont des codes linéaires et ils peuvent donc être décrits à l'aide de la matrice de parité du code. Chaque ligne correspond à un bit de vérification et chaque colonne à un bit d'information utile ou a un bit de vérification selon sa position. Un 1 situé à l'intersection d'une ligne et d'une colonne dans la matrice de parité du code indique une dépendance entre les bits correspondants. A l'inverse, un 0 indique une indépendance. Les bits de vérification sont calculés à l'aide de sommes modulo 2 sur les bits de dépendance indiqués par la ligne de la matrice de parité qui correspond au bit de vérification concerné.

Les codes de Hamming étendus sont décrits notamment dans le livre de P.K. Lala intitulé Self-Checking and Fault-Tolerant Design, San-Francisco, Morgan Kaufmann, 2001. Ces codes de Hamming sont dits étendus car un bit de vérification a été ajouté par rapport au code de Hamming classique. Ce bit de vérification a pour rôle de vérifier la parité totale du mot de code.

La matrice de parité de la figure 2 correspond à un exemple de code de Hamming étendu pour lequel chaque mot de code comprend 16 bits d'information notée de D0 à D15 et 6 bits de vérification notés de C0 à C5. La matrice de parité de ce code comprend donc 6 lignes et 22 colonnes. Parmi ces colonnes, 6 colonnes 200 correspondent aux bits de vérification et 16 colonnes 201 correspondent aux bits de données. Le bit de vérification C0 est le bit vérifiant la parité globale du mot de code, appelée également parité totale dans la suite de la description. La première ligne de la matrice 202 est par conséquent remplie de 1.

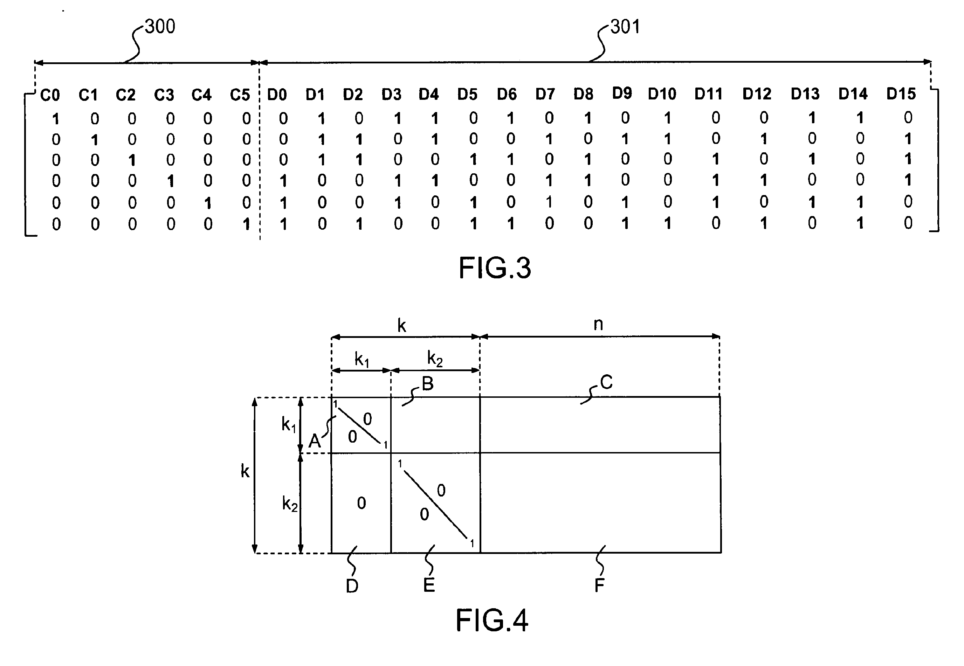

La figure 3 donne un exemple de matrice de parité pour un code de Hsiao. Comme introduit précédemment, les codes de Hsiao sont des codes SECDED communément utilisés. Ces codes sont notamment décrits dans l'article de C.L. Chen et M.Y. Hsiao intitulé Error-correcting codes for semiconductor memory applications : a state of the art review, Reliable Computer Systems - Design and Evaluation, Digital Press, 2nd edition, 1992, pages 771-786.

A la différence des codes de Hamming étendus disposant d'un seul bit pour vérifier la parité de l'ensemble du mot codé, dans les codes de Hsiao tous les bits de vérification sont utilisés pour imposer la parité de l'ensemble du mot codé. Pour cela, les codes de Hsiao sont construits en imposant un nombre impair de 1 pour chaque colonne de la matrice de parité du code. La matrice de parité de la figure 3 correspond à un exemple de code de Hsiao.

Chaque mot de code comprend 16 bit d'information notés de D0 à D15 et 6 bits de vérification notés de C0 à C5. Par conséquent 6 colonnes 300 correspondent aux bits de vérification et 16 colonnes 301 correspondent aux bits de données.

La figure 4 illustre les caractéristiques des matrices de parité représentatives du procédé de codage selon l'invention. La famille de code correcteur d'erreur découlant de l'invention est appelée dans la suite de la description code à bits de parité totale et désigné par l'acronyme BPT.

Dans la suite de la description, le syndrome d'un mot de code est défini comme étant le résultat d'un OU exclusif logique appliqué bit à bit entre les bits de vérification et les bits de vérification recalculés à partir des bits de données du mot de code à décoder. Cette opération peut s'exprimer à l'aide de l'équation suivante :

$$(S0, S1,\ldots, Sk\text{-}1) = (C0', C1', \ldots, Ck\text{-}1') \oplus (C0'', C1'', \ldots, Ck\text{-}1'') \qquad (1)$$

dans laquelle :

$\oplus$ représente l'opération OU exclusif logique ;
$Si$ représente le $i^{\text{ème}}$ bit du syndrome ;
$Ci'$ représente le $i^{\text{ème}}$ bit de vérification du mot de code à décoder ;
$Ci''$ représente le $i^{\text{ème}}$ bit de vérification recalculé à partir des bits de données du mot de code à décoder ;
$k$ est le nombre de bits de vérification du mot de code.

Le procédé de codage ainsi que la famille de codes qui lui sont associés proposés dans le cadre de l'invention permettent l'utilisation de tous les bits de vérification pour faire la distinction entre les syndromes correspondant aux bits erronés. C'est le cas du code de Hsiao, mais ce n'est pas le cas du code de Hamming étendu dans lequel le bit de parité totale est utilisé pour distinguer le syndrome indiquant une erreur sur ce même bit.

La matrice de parité H utilisée par le procédé de codage selon l'invention peut être décomposée en 6 sous-matrices A, B, C, D, E et F. Pour coder les blocs d'information utile de n bits en ajoutant k bits de vérification, une matrice de parité comportant $m = k + n$ colonnes et k lignes est utilisée. Les bits de vérifications sont séparés en deux groupes, d'une part un groupe de k1 bits appelés bits de parité totale et d'autre part un groupe de k2 bits appelés bits de vérification classique, avec $k1 + k2 = k$. Dans la suite de la description, les bits de parité totale sont désignés par l'acronyme PT et les bits de vérification classique sont désignés par l'acronyme VC.

La sous-matrice A est une matrice carrée composée des éléments binaires à l'intersection des k1 premières colonnes et des k1 premières lignes de la matrice H. La sous-matrice A est une matrice unité, c'est-à-dire qu'elle est composée de zéro sauf sur sa diagonale descendante.

La sous-matrice B est composée des éléments binaires à l'intersection des colonnes k1 + 1 à k1 + k2 et des k1 premières lignes de la matrice H.

La sous-matrice C est composée des éléments à l'intersection des n dernières colonnes et des k1 premières lignes de la matrice H.

Les sous-matrices B et C sont construites en garantissant un nombre impair de 1 pour chaque colonne desdites matrices.

La sous-matrice D est composée des éléments binaires à l'intersection des k1 premières colonnes et des k2 dernières lignes de la matrice H. La sous-matrice D est une matrice nulle, c'est-à-dire qu'elle est composée uniquement de zéros.

La sous-matrice E est une matrice carrée composée des éléments binaires à l'intersection des colonnes k1 + 1 à k1 + k2 et des k2 dernières lignes de la matrice H. La sous-matrice E est une matrice unité, c'est-à-dire qu'elle est composée de zéro sauf sur sa diagonale descendante.

La sous-matrice F est composée des éléments binaires à l'intersection des n dernières colonnes et des k2 dernières lignes de la matrice H. La sous-matrice F est construite telle que les colonnes de la matrice H sont différentes.

Pour générer des mots de code en utilisant le procédé selon l'invention, la matrice de parité doit être construite telle que k et k1 vérifient l'inégalité suivante :

$$k > k1 > 2 \qquad (2)$$

La sous matrice définie par la réunion des matrices A, B et C est appelée sous-matrice de parité du code. En construisant la matrice H selon les règles exposées ci-dessus, chaque colonne de la sous-matrice de parité comprend un nombre impair de 1.

Contrairement au code de Hsiao, le nouveau code permet l'existence de colonnes avec un nombre pair de 1 dans la partie de la matrice du code correspondant aux bits d'information utile, c'est-à-dire la partie correspondant aux sous-matrices C et F. Cette propriété se traduit, lorsque le code est mis en oeuvre sur un circuit de codage, par une réduction de la surface en Silicium, par exemple, et permet d'augmenter la performance en termes de vitesse d'exécution de l'encodeur et du décodeur.

En plus de la capacité SECDED classique, des variations spéciales du nouveau code BPT permettent de détecter d'une manière efficace des erreurs multiples, c'est-à-dire des erreurs impliquant la corruption de plusieurs bits du mot de code. Au sens de cette définition, les erreurs doubles sont considérées comme un cas particulier des erreurs multiples.

Au moins deux types d'erreurs multiples peuvent être distingués. Dans la suite de la description, le premier type est désigné par l'expression « erreur burst », et le second par l'expression « erreur range ». Une erreur burst affecte un groupe de m bits voisins correspondant à des colonnes voisines dans la matrice de parité du code. Par exemple, si les bits D0, D1, D2, D3 sont faux, c'est une erreur burst de longueur 4 et cette erreur sera notée burst(4).

Une erreur qui affecte les bits D0, D2, D3, D4 n'est pas une erreur burst. Une erreur range est une erreur qui affecte i bits dans un groupe de j bits voisins ($i \leq j$). Ce type d'erreur est désigné par la notation range(i, j). Par exemple, l'erreur qui affecte les bits D0, D2, D3, D4 est une erreur range(4, 5).

Il est considéré dans la suite de la description que si un code peut détecter toutes les erreurs de type burst(l) et range(i, j), alors toutes les erreurs burst(l') et range(i', j') sont aussi détectable avec les conditions $l' \leq l$, $i' \leq 1$ et $j' \leq j$. De plus, une erreur burst(l) est incluse dans range(i, j) si $l \leq i$.

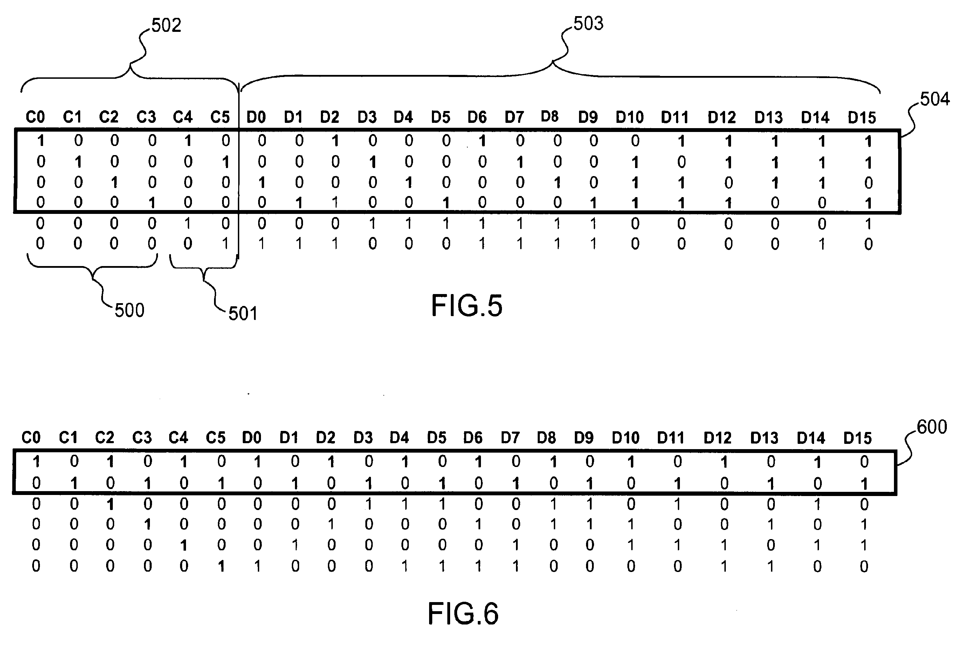

La figure 5 donne un exemple de matrice de parité d'un code BPT. Dans cet exemple, un mot de code comprend 16 bits notés D0 à D15 d'information utile 503. Les 6 bits 502 de vérification C0, C1, C2, C3, C4 et C5 sont divisés en deux groupes. Le premier groupe 500 comprend 4 bits de parité totale C0, C1, C2, C3. Le second groupe 501 comprend 2 bits de vérification classiques C4 et C5. Les paramètres définis précédemment prennent donc comme valeurs k = 6, k1 = 4 et k2 = 2 et n = 16. La sous-matrice de parité comprend par conséquent 4 lignes et 22 colonnes.

A partir du code BPT selon l'invention, des cas particuliers possédant des propriétés intéressantes en termes de détection d'erreur peuvent être distingués. A titre d'exemple, des codes appelés codes avec bits de parité totale complémentaires et désignés par l'acronyme BPTC, sont décrits dans la suite de la description.

La figure 6 présente une matrice de parité correspondant à un exemple de code BPTC comprenant 2 bits PT complémentaires.

Ces codes sont un cas particulier des codes BPT et sont construits en ajoutant une contrainte supplémentaire lors de la construction de la matrice de parité. Cette contrainte est que chaque colonne de la sous-matrice de parité doit n'avoir qu'un seul 1. L'ensemble des bits du mot codé est alors partitionné en plusieurs sous-ensembles, tel que pour chaque sous-ensemble il y ait un bit de vérification, ledit bit de vérification permettant d'assurer la parité de ce sous-ensemble.

Ces bits de vérification sont dits bits de parité totale complémentaires et sont désignés par l'acronyme PTC. Ils sont appelés ainsi parce que les sous-ensembles de bits du mot de code dont ils assurent la parité sont complémentaires. En d'autre termes, les lignes de la sous matrice de parité ont deux propriétés.

La première est que les colonnes de la sous-matrice de parité n'ont qu'un seul 1.

La seconde est que l'addition des k1 matrices lignes de longueur m = k + n correspondant aux k1 lignes de la sous-matrice de parité est égale à une matrice ligne remplie de 1.

La matrice de la figure 6 est un exemple de matrice de parité pour un code BPTC utilisant 2 bits PTC. Les deux bits PTC C0 et C1 sont utilisés pour couvrir la totalité du mot de code. Les 2 premières lignes de la matrice du code correspondant à C0 et C1 couvrent chacune la parité d'une moitié des bits du mot de code. Ainsi, deux erreurs sur 2 bits voisins sont facilement détectées par les dépendances relatives aux parités de C0 et C1. Dans cet exemple, la sous-matrice de parité 600 comprend 2 lignes et le même nombre de colonnes que la matrice de parité entière.

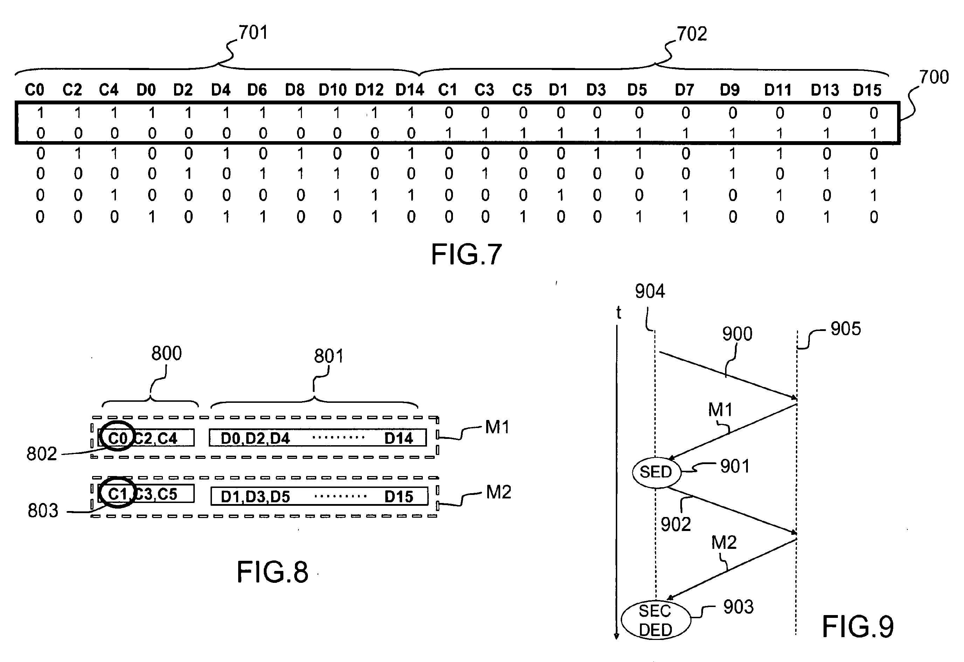

La figure 7 présente une matrice de parité correspondant à un exemple de code à 2 bits PTC et dont les mots de code sont dissociables en deux sous-ensembles contigus. En effet, les colonnes de la matrice de parité d'un code BPTC peuvent être permutées. Ainsi, les colonnes de la matrice de parité de la figure 6 ont été réordonnées afin que les 2 sous-ensembles 701, 702 du mot codé soient plus faciles à dissocier. Chacun des deux bits PTC C0 et C1 permet la détection d'erreurs simples, ainsi que toutes les erreurs qui affectent un nombre impair de bits, et ce dans chaque sous-ensemble 701, 702 en lisant uniquement ce sous-ensemble. La lecture du mot codé entier offre quant à elle la capacité SECDED. Cette dissociation est apparente dans la sous-matrice de parité 700 où les 1 des deux lignes correspondants aux bits PTC sont regroupés au niveau de chaque sous ensemble 701, 702.

La figure 8 donne un exemple de séparation d'un mot de code généré par le procédé selon l'invention en deux sous-ensembles M1, M2. En d'autres termes, un mot de code est coupé en deux mots M1, M2 pour être stockés et/ou transmis sur un média de communication. L'exemple de la figure 8 découle de la matrice de parité présenté à l'aide de la figure 7. Les deux sous-ensembles résultant du découpage d'un mot de code comprennent 3 bits de vérifications 800 et 8 bits de données 801. Chaque sous-ensemble comprend, dans cet exemple, un bit PT 802, 803 parmi ses bits de vérification. Dans un exemple d'implémentation, les sous-ensembles M1, M2 du mot de code sont mis dans une mémoire dont la largeur d'un mot mémoire est celle d'un sous-ensemble. Les deux sous-ensembles du mot de code sont alors placés dans deux mots différents de la mémoire ou/et transmis sur un média qui transporte les bits, par exemple, avec la granularité d'un sous-ensemble du mot codé.

La lecture d'un seul des mots de la mémoire bénéficie de la capacité de détection d'une erreur simple SED, acronyme venant de l'expression anglo-saxonne « Single Error Detection », et ce grâce à la présence du bit PT 802, 803 de chaque sous-ensemble. La lecture de tous les mots mémoire correspondant aux sous-ensembles d'un même mot de code bénéficie de la capacité SECDED.

La figure 9 donne un exemple de protocole permettant d'exploiter la propriété de séparation en sous-ensembles d'un mot de code généré par le procédé selon l'invention. Un exemple d'échanges pouvant être mis en oeuvre entre un équipement maître 904 voulant accéder à des données contenu dans une mémoire 905 est explicité ci-après. Les échanges de messages de contrôle et de données sont effectués, par exemple, en utilisant un bus.

L'équipement maître 904 envoie une requête de lecture 900. En réponse, le premier sous-ensemble M1 d'un mot de code stocké en mémoire 905 est envoyé à l'équipement maître. La détection d'une erreur peut être faite dès l'accès à un seul sous-ensemble au lieu de devoir attendre d'avoir accès à l'ensemble d'un mot de code. Une détection d'erreur SED 901 est réalisée. La détection d'une erreur peut donc être faite rapidement. Ainsi, l'accès à tous le mot codé peut être réalisé uniquement lorsqu'il est nécessaire d'accéder à toute la donnée qu'elle contient, ou bien pour corriger une erreur qui a été détectée dans un des sous-ensembles. Dans l'exemple de la figure, une seconde requête 902 est envoyée afin d'accéder au deuxième sous-ensemble M2 du mot de code. Ledit sous-ensemble alors est envoyé à l'équipement maître et le mot de code reçu entièrement bénéficie de la capacité de correction d'erreur simple et de la détection d'erreur multiple 903 du procédé selon l'invention.

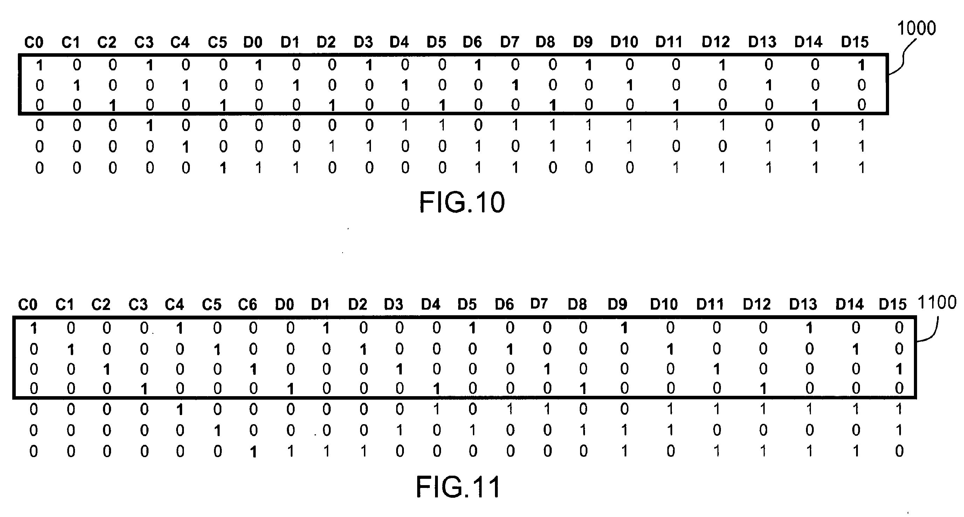

La figure 10 présente une matrice de parité correspondant à un exemple de code BPTC à 3 bits PTC. Il est possible de construire des matrices de parités pour générer des codes selon l'invention en utilisant, par exemple, 3 bits PTC ou plus. Dans l'exemple de la figure, C0, C1 et C2 sont les bits de parité totale complémentaires. C3, C4 et C5 sont les bits VC. Pour générer, par exemple, des mots de code comprenant 16 bits d'information utile notés D0 à D15, la sous-matrice de parité 1000 comprend 3 lignes et 22 colonnes. En plus de la capacité SECDED, il est alors possible de détecter des erreurs burst(4), c'est-à-dire des paquets d'erreurs affectant quatre bits voisins d'un mot de code. Ceci est ici réalisé de façon efficacement car seuls les bits PTC sont mis à contribution pour réaliser cette détection, les bits VC ne sont eux nécessaires que pour la correction. Cela est réalisable tout en dissociant leurs syndromes de ceux des erreurs simples corrigeables et permet ainsi d'éviter de réaliser de mauvaises corrections.

La figure 11 présente un exemple de matrice de parité pour un code BPTC utilisant 4 bits PTC (C0, C1, C2, C3). Ledit code associe 6 bits de vérification C0 à C5 aux 16 bits de donnée D0 à D15. La sous-matrice de parité 1100 est donc composée de 22 colonnes et 4 lignes. En plus de la capacité SECDED classique, il est ici possible de détecter des erreurs burst(6) et range(4, 4). Le syndrome d'un mot erroné affecté par ces erreurs *burst* ou *range* aura toujours au moins 2 bits égaux à 1 dans la partie correspondant aux bits PTC.

Dans le cas d'une erreur burst(6) sur les bits C5, C6, D0, D1, D2 et D3, les bits du syndrome correspondant aux bits PTC forment une combinaison non-utilisée pour la correction des erreurs simple. En effet, le syndrome correspondant aux bits PTC obtenu est dans ce cas :

$$(S0, S1, S2, S3) = (1, 0, 0, 1) \qquad\qquad (3)$$

Dans le cas d'une erreur range(3, 4) sur les bits C5, C6 et D1, les bits du syndrome correspondant aux bits PTC forment une combinaison non-utilisée pour la correction des erreurs simples. Le syndrome correspondant aux bits PTC suivant est obtenu :

$$(S0, S1, S2, S3) = (1, 1, 1, 0) \qquad\qquad (4)$$

Le procédé de codage selon l'invention, que ce soit pour les codes BPT ou BPTS, peut être mis en oeuvre notamment dans un circuit électronique ou un ordinateur.

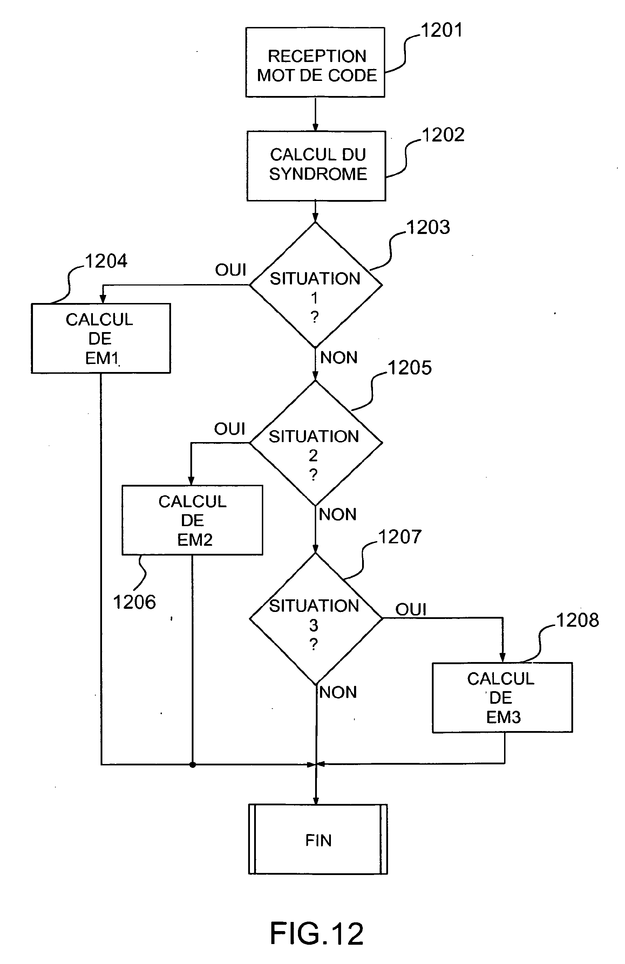

La figure 12 illustre un exemple d'algorithme de détection d'erreur multiple.

Si le syndrome calculé est nul il n'y a pas d'erreur détectée. Dans le cas des codes SECDED avec des bits PTC, il est possible de distinguer trois cas facilement identifiables qui dénotent la présence d'une erreur multiple. L'algorithme de détection présenté à l'aide de la figure 12 a pour but de détecter ces trois cas. Une fois le mot de code reçu 1201, le syndrome dudit mot est calculé 1202, par exemple, tel qu'explicité précédemment dans la description.

Le premier cas à détecter correspond à la situation où tous les bits du syndrome correspondant aux bits PTC sont nuls 1203. Le nombre de bits non nuls du syndrome correspondant aux bits PTC est noté Nsc. Donc, si Nsc = 0, le premier cas est détecté. En d'autres termes, le nombre des bits erronés dans chaque sous ensemble des bits du mot codé dépendant d'un même bit de parité totale est pair, mais il reste un ou plusieurs autres bits Si de syndrome non-nuls. Dans ce cas, la présence d'erreurs multiples est détecté 1204 lorsque l'indicateur EM1 défini par l'expression ci-dessous vaut 1 :

$$EM1 = \left( \overline{\bigvee_{i=0}^{k1-1} Si} \right) \wedge \left( \bigvee_{j=k1}^{k-1} Sj \right) \tag{5}$$

dans laquelle :

  $\wedge$ indique une opération OU logique ;
  $\wedge$ indique une opération ET logique ;
  k représente le nombre de bits de syndrome ;
  k1 représente le nombre de bits de PTC ;
  $\overline{x}$ représente le complémentaire de x ;
  Si représente le $i^{\text{ème}}$ bit du syndrome ;
  Sj représente le $j^{\text{ème}}$ bit du syndrome ;

Le deuxième cas à détecter 1205 dénotant la présence d'erreurs multiples correspond à la situation pour laquelle plus d'un des bits de syndrome correspondant aux bits de parité complémentaires sont non nuls, soit Nsc > 1. Par conséquent, dans un code SECDED avec k1 (k1>2) bits de parité complémentaires où les bits des k1 sous ensembles sont entrelacés, il est possible de détecter de manière efficace toutes les erreurs multiples de type burst(2xk1-2) et toutes les erreurs multiples de type range(k1, k1). Dans ces deux cas, 2 bits au moins sont égaux à 1 dans la partie du syndrome correspondant aux bits de parité complémentaires. Une erreur multiple est alors détectée 1206 lorsque l'indicateur EM2 défini par l'expression ci-dessous vaut 1 :

$$EM2 = \left( \bigvee_{i=0}^{k1-1} Si \right) \wedge \left( \bigvee_{j=i+1}^{k1-1} Sj \right) \tag{6}$$

Le troisième cas à détecter 1207 dénotant la présence d'erreurs multiples correspond à la situation ou les bits de syndrome correspondant aux bits VC forment une combinaison non-utilisée pour l'identification des erreurs simples. Une erreur multiple est alors détectée 1208 lorsque l'indicateur EM3 défini par l'expression ci-dessous vaut 1 :

$$EM3 = \bigvee_{\pi \in \Pi} \left[ \left( \bigwedge_{i=k1 \, avec \, \pi(i)=1}^{k-1} Si \right) \wedge \left( \bigwedge_{i=k1 \, avec \, \pi(i)=0}^{k-1} \overline{Si} \right) \right] \tag{7}$$

dans laquelle :

  $\pi$ : {k1, k1 +1, ..., k-1} $\rightarrow$ {0, 1} est une fonction indiquant une combinaison des k2 bits VC du syndrome dans laquelle le complément des bits Si (k1$\leq$i<k) est pris si $\pi$(i)=0 ;
  $\Pi$ est l'ensemble de combinaisons $\pi$ non-utilisé pour l'identification des erreurs simples.

Un exemple de méthode de détection d'erreurs multiples dans le cas du code BPT est décrit ci-après. Dans le cas des codes BPT trois cas dénotant la présence d'une erreur multiple sont facilement identifiables grâce au calcul de trois indicateurs EM1, EM2 et EM3 défini pour le cas plus général des codes BPT.

Dans un premier cas, le mot de code a la bonne parité totale, mais il existe des bits non-nuls sur l'ensemble des bits de syndrome. Dans ce cas, une erreur multiple est détectée en utilisant l'expression suivante :

$$EM1 = \left( \overline{\bigoplus_{i=0}^{k1-1} Si} \right) \wedge \left( \bigvee_{j=0}^{k-1} Sj \right) \qquad (8)$$

Dans un deuxième cas dénotant la présence d'une erreur multiple, les bits de syndrome qui correspondent aux bits de PT forment une combinaison non-utilisée pour l'identification des erreurs simples.

$$EM2 = \bigvee_{\delta \in \Delta} \left[ \left( \bigwedge_{i=0 \ avec \ \delta(i)=1}^{k1-1} Si \right) \wedge \left( \bigwedge_{i=0 \ avec \ \delta(i)=0}^{k1-1} \overline{Si} \right) \right] \qquad (9)$$

dans laquelle :

$\delta$ : {0, 1, ..., k1-1} $\rightarrow$ {0, 1} est une fonction indiquant une combinaison des k1 bits PT du syndrome dans laquelle le complément des bits Si ($0 \leq i < k1$) est pris si $\delta(i)=0$ ;
$\Delta$ est l'ensemble de combinaisons $\delta$ non-utilisées pour l'identification des erreurs simples.

Dans un troisième cas dénotant la présence d'une erreur multiple, les bits de syndrome correspondant aux bits VC forment une combinaison non-utilisée pour l'identification des erreurs simples. Cette détection est faite de la façon décrite par l'équation (7).
Le procédé de détection d'erreurs multiples peut être mis en oeuvre notamment dans un circuit électronique ou un ordinateur.
L'implémentation matérielle des expressions (5), (6) et (8) est évidente pour un homme du métier. L'efficacité des implémentations des expressions (7) et (9) est facilitée par le fait que la première ne dépend pas des bits de parité et par le fait que la seconde dépend seulement des bits de parité. De plus, surtout dans le cas de l'expression (7), seul un sous-ensemble des combinaisons non-utilisées pour l'identification des erreurs simples peut être utilisé pour l'identification des erreurs multiples.
Pour la détection des erreurs doubles dans le cas du code de Hsiao, la parité totale peut être calculée notamment en utilisant deux méthodes distinctes. Dans la première méthode, un OU exclusif logique est appliqué entre tous les bits du syndrome ce qui a un impact négatif sur les performances de calcul du décodeur. Dans la seconde méthode, un OU exclusif logique est appliqué entre tous les bits du mot de code à décoder ce qui a un impact négatif sur la surface du circuit de décodage.
Ces deux inconvénients n'interviennent pas dans le cas des codes BPTC et dans certains cas des codes BPT.

## Revendications

1. Procédé de codage correcteur d'erreur générant des mots de code de m bits à partir de blocs de données utiles de n bits, ledit procédé ajoutant k bits de vérification à un bloc de n bits de données utiles afin de générer un mot de code de m = n + k bits, lesdits bits de vérification étant définis en suivant les règles de combinaison définies par une matrice de parité H composée d'éléments binaires et comportant k lignes et m colonnes tels que H.V = 0, V étant une matrice colonne dont les m éléments sont les m bits du mot de code à générer, ledit procédé étant **caractérisé en ce que** les k bits de vérification sont séparés en deux groupes, d'une part un groupe de k1 bits appelés bits de parité totale PT et d'autre part un groupe de k2 bits appelés bits de vérification classiques VC, les valeurs de k, k1 et k2 vérifiant les conditions k = k1 + k2 et k > k1 > 2, la matrice H dont les colonnes sont aptes à être permutées étant décomposée en 6 sous-matrices A, B, C, D, E et F, lesdites sous-matrices étant définies telles que :

- la sous-matrice A est une matrice carrée composée des éléments binaires à l'intersection des k1 premières colonnes et des k1 premières lignes de la matrice H, la sous-matrice A étant une matrice unité ;
- la sous-matrice B est composée des éléments binaires à l'intersection des colonnes k1+1 à k1+k2 et des k1 premières lignes de la matrice H et comprend un nombre impair de 1 par colonne ;
- la sous-matrice C est composée des éléments binaires à l'intersection des n dernières colonnes et des k1 premières lignes de la matrice H et comprend un nombre impair de 1 par colonne ;
- la sous-matrice D est composée des éléments binaires à l'intersection des k1 premières colonnes et des k2 dernières lignes de la matrice H et est une matrice nulle ;
- la sous-matrice E est une matrice carrée composée des éléments binaires à l'intersection des colonnes k1+1 à k1+k2 et des k2 dernières lignes de la matrice H et est une matrice unité ;
- la sous-matrice F est composée des éléments binaires à l'intersection des n dernières colonnes et des k2 dernières lignes de la matrice H telle que les colonnes de la matrice H sont différentes.

**2.** Procédé de codage correcteur d'erreur selon la revendication 1 **caractérisé en ce que** la matrice résultant de la réunion des trois sous-matrices A, B, C de la matrice de parité H et appelée sous-matrice de parité (600) est construite telle que chaque colonne comprend un 1.

**3.** Procédé de codage correcteur d'erreur selon la revendication 2 **caractérisé en ce que** les colonnes de la matrice H de parité du code sont permutées de manière à ce qu'un mot de code généré par le procédé selon l'invention est composé de plusieurs sous-ensembles contigus de bits, chaque sous-ensemble de bits comprenant au moins un des bits de parité totale PT.

**Claims**

**1.** A method for error correcting coding, generating code words of m bits from useful data blocks of n bits, said method adding k check bits to a block of n useful data bits so as to generate a code word of m = n + k bits, said check bits being defined according to the combination rules defined by a parity matrix H composed of binary elements and comprising k rows and m columns so that H.V = 0, V being a column matrix for which the m elements are the m bits of the code word to be generated, said method being **characterised in that** the k check bits are separated into two groups, on the one hand a group of k1 bits, referred to as total parity bits PT, and on the other hand a group of k2 bits, referred to as conventional check bits VC, the values of k, k1 and k2 checking the conditions k = k1 + k2 and k > k1 > 2, the matrix H, for which the columns are designed to be permutated, being divided into 6 sub-matrices A, B, C, D, E and F, said sub-matrices being defined so that:

- the sub-matrix A is a square matrix composed of binary elements at the intersection of k1 first columns and k1 first rows of the matrix H, the sub-matrix A being a unity matrix;
- the sub-matrix B is composed of binary elements at the intersection of columns k1+1 to k1+k2 and the k1 first rows of the matrix H and comprise an odd number of 1 per column;
- the sub-matrix C is composed of binary elements at the intersection of the n last columns and the k1 first rows of the matrix H and comprise an odd number of 1 per column;
- the sub-matrix D is composed of binary elements at the intersection of the k1 first columns and the k2 first rows of the matrix H and is a zero matrix;
- the sub-matrix E is a square matrix composed of binary elements at the intersection of columns k1+1 to k1+k2 and the k2 last rows of the matrix H and is a unity matrix;
- the sub-matrix F is composed of binary elements at the intersection of the n last columns and the k2 last rows of the matrix H so that the columns of the matrix H are different.

**2.** The method for error correcting coding according to claim 1, **characterised in that** the matrix resulting from the merging of the three sub-matrices A, B, C of the parity matrix H, and which is referred to as a parity sub-matrix (600), is constructed so that each column comprises a 1.

**3.** The method for error correcting coding according to claim 2, **characterised in that** the columns of the parity matrix H of the code are permutated so that a code word generated by the method according to the invention is composed of a plurality of contiguous sub-sets of bits, each sub-set of bits comprising at least one of the total parity bits PT.

**Patentansprüche**

**1.** Fehlerkorrekturcodierverfahren unter Erzeugung von Codewörtern von m Bits von nützlichen Datenblöcken von n Bits, wobei das Verfahren k Prüfbits zu einem Block von n nützlichen Datenbits hinzufügt, um ein Codewort von m = n + k Bits zu erzeugen, wobei die Prüfbits nach Kombinationsregeln definiert werden, die durch eine Paritätsmatrix H definiert werden, die aus binären Elementen zusammengesetzt ist und k Reihen und m Spalten umfasst, so dass H.V = 0 ist, wobei V eine Spaltenmatrix ist, deren m Elemente die m Bits des zu erzeugenden Codeworts sind, wobei das Verfahren **dadurch gekennzeichnet ist, dass** die k Prüfbits in zwei Gruppen unterteilt sind, einerseits eine Gruppe von k1 Bits, Gesamtparitätsbits PT genannt, und andererseits eine Gruppe von k2 Bits, herkömmliche Prüfbits VC genannt, wobei die Werte von k, k1 und k2 die Bedingungen k = k1 + k2 und k > k1 > 2 prüfen, wobei die Matrix H, deren Spalten vertauscht werden können, in 6 Submatrizen A, B, C, D, E und F unterteilt sind, wobei die Submatrizen so definiert sind, dass:

- Submatrix A eine quadratische Matrix ist, die aus binären Elementen am Schnittpunkt der k1 ersten Spalten und der k1 ersten Reihen der Matrix H zusammengesetzt ist, wobei Submatrix A eine Einheitsmatrix ist;
- Submatrix B aus binären Elementen am Schnittpunkt der Spalten k1+1 bis k1+k2 und der k1 ersten Reihen der Matrix H zusammengesetzt ist und eine ungerade Zahl von Einsen pro Spalte umfasst;
- Submatrix C aus binären Elementen am Schnittpunkt der n letzten Spalten und der k1 ersten Reihen der Matrix H zusammengesetzt ist und eine ungerade Zahl von Einsen pro Spalte umfasst;
- Submatrix D aus binären Elementen am Schnittpunkt der k1 ersten Spalten und der k2 ersten Reihen der Matrix H zusammengesetzt ist und eine Null-Matrix ist;
- Submatrix E eine quadratische Matrix ist, die aus binären Elementen am Schnittpunkt der Spalten k1+1 bis k1+k2 und der k2 letzten Reihen der Matrix H zusammengesetzt ist und eine Einheitsmatrix ist;
- Submatrix F aus binären Elementen am Schnittpunkt der n letzten Spalten und der k2 letzten Reihen der Matrix H zusammengesetzt ist, so dass die Spalten der Matrix H unterschiedlich sind.

**2.** Fehlerkorrekturcodierverfahren nach Anspruch 1, **dadurch gekennzeichnet, dass** die aus der Zusammenführung der drei Submatrizen A, B, C der Paritätsmatrix H resultierende Matrix, Paritäts-Submatrix (600) genannt, so aufgebaut ist, dass jede Spalte eine 1 umfasst.

**3.** Fehlerkorrekturcodierverfahren nach Anspruch 2, dadurch gekennzeichnet, dass die Spalten der Paritätsmatrix H des Codes vertauscht werden, so dass ein mit dem erfindungsgemäßen Verfahren erzeugtes Codewort aus mehreren zusammenhängenden Teilmengen von Bits zusammengesetzt ist, wobei jede Teilmenge von Bits wenigstens eines der Gesamtparitätsbits PT umfasst.

EP 2 394 366 B1

102

100  101

$C_0$  $C_5$  $D_0$  $D_{15}$

011010  0100001111101010

## FIG.1

200  201

| C0 | C1 | C2 | C3 | C4 | C5 | D0 | D1 | D2 | D3 | D4 | D5 | D6 | D7 | D8 | D9 | D10 | D11 | D12 | D13 | D14 | D15 |
|----|----|----|----|----|----|----|----|----|----|----|----|----|----|----|----|-----|-----|-----|-----|-----|-----|
| 1  | 1  | 1  | 1  | 1  | 1  | 1  | 1  | 1  | 1  | 1  | 1  | 1  | 1  | 1  | 1  | 1   | 1   | 1   | 1   | 1   | 1   |
| 0  | 1  | 0  | 0  | 0  | 0  | 0  | 1  | 0  | 0  | 1  | 0  | 0  | 1  | 1  | 0  | 1   | 1   | 0   | 1   | 0   | 1   |
| 0  | 0  | 1  | 0  | 0  | 0  | 0  | 1  | 1  | 0  | 0  | 0  | 1  | 0  | 0  | 1  | 1   | 1   | 0   | 0   | 1   | 0   |
| 0  | 0  | 0  | 1  | 0  | 0  | 0  | 0  | 1  | 1  | 0  | 1  | 0  | 1  | 0  | 0  | 1   | 0   | 1   | 0   | 1   | 1   |
| 0  | 0  | 0  | 0  | 1  | 0  | 1  | 0  | 0  | 0  | 1  | 1  | 0  | 0  | 0  | 1  | 0   | 1   | 1   | 1   | 0   | 1   |
| 0  | 0  | 0  | 0  | 0  | 1  | 1  | 0  | 0  | 1  | 0  | 0  | 1  | 0  | 1  | 0  | 0   | 0   | 1   | 1   | 1   | 0   |

202

## FIG.2

| C0 | C1 | C2 | C3 | C4 | C5 | D0 | D1 | D2 | D3 | D4 | D5 | D6 | D7 | D8 | D9 | D10 | D11 | D12 | D13 | D14 | D15 |
|----|----|----|----|----|----|----|----|----|----|----|----|----|----|----|----|-----|-----|-----|-----|-----|-----|
| 1 | 0 | 0 | 0 | 0 | 0 | 0 | 1 | 0 | 1 | 1 | 0 | 1 | 0 | 1 | 0 | 1 | 0 | 0 | 1 | 1 | 0 |
| 0 | 1 | 0 | 0 | 0 | 0 | 0 | 1 | 1 | 0 | 1 | 0 | 0 | 1 | 0 | 1 | 1 | 0 | 1 | 0 | 0 | 1 |
| 0 | 0 | 1 | 0 | 0 | 0 | 0 | 1 | 1 | 0 | 0 | 1 | 1 | 0 | 1 | 0 | 0 | 1 | 0 | 1 | 0 | 1 |
| 0 | 0 | 0 | 1 | 0 | 0 | 1 | 0 | 0 | 1 | 1 | 0 | 0 | 1 | 1 | 0 | 0 | 1 | 1 | 0 | 0 | 1 |
| 0 | 0 | 0 | 0 | 1 | 0 | 1 | 0 | 0 | 1 | 0 | 1 | 0 | 1 | 0 | 1 | 0 | 1 | 0 | 1 | 1 | 0 |
| 0 | 0 | 0 | 0 | 0 | 1 | 1 | 0 | 1 | 0 | 0 | 1 | 1 | 0 | 0 | 1 | 1 | 0 | 1 | 0 | 1 | 0 |

FIG.3

FIG.4

EP 2 394 366 B1

| C0 | C1 | C2 | C3 | C4 | C5 | D0 | D1 | D2 | D3 | D4 | D5 | D6 | D7 | D8 | D9 | D10 | D11 | D12 | D13 | D14 | D15 |
|----|----|----|----|----|----|----|----|----|----|----|----|----|----|----|----|-----|-----|-----|-----|-----|-----|
| 1 | 0 | 0 | 0 | 1 | 0 | 0 | 0 | 1 | 0 | 0 | 0 | 1 | 0 | 0 | 0 | 0 | 1 | 1 | 1 | 1 | 1 |
| 0 | 1 | 0 | 0 | 0 | 1 | 0 | 0 | 0 | 1 | 0 | 0 | 0 | 1 | 0 | 0 | 1 | 0 | 1 | 1 | 1 | 1 |
| 0 | 0 | 1 | 0 | 0 | 0 | 1 | 0 | 0 | 0 | 1 | 0 | 0 | 0 | 1 | 0 | 1 | 1 | 0 | 1 | 1 | 0 |
| 0 | 0 | 0 | 1 | 0 | 0 | 0 | 1 | 1 | 0 | 0 | 1 | 0 | 0 | 0 | 1 | 1 | 1 | 1 | 0 | 0 | 1 |
| 0 | 0 | 0 | 0 | 1 | 0 | 0 | 0 | 0 | 1 | 1 | 1 | 1 | 1 | 1 | 1 | 0 | 0 | 0 | 0 | 0 | 1 |
| 0 | 0 | 0 | 0 | 0 | 1 | 1 | 1 | 1 | 0 | 0 | 0 | 1 | 1 | 1 | 1 | 0 | 0 | 0 | 0 | 1 | 0 |

## FIG.5

| C0 | C1 | C2 | C3 | C4 | C5 | D0 | D1 | D2 | D3 | D4 | D5 | D6 | D7 | D8 | D9 | D10 | D11 | D12 | D13 | D14 | D15 |
|----|----|----|----|----|----|----|----|----|----|----|----|----|----|----|----|-----|-----|-----|-----|-----|-----|
| 1 | 0 | 1 | 0 | 1 | 0 | 1 | 0 | 1 | 0 | 1 | 0 | 1 | 0 | 1 | 0 | 1 | 0 | 1 | 0 | 1 | 0 |
| 0 | 1 | 0 | 1 | 0 | 1 | 0 | 1 | 0 | 1 | 0 | 1 | 0 | 1 | 0 | 1 | 0 | 1 | 0 | 1 | 0 | 1 |
| 0 | 0 | 1 | 0 | 0 | 0 | 0 | 0 | 0 | 1 | 1 | 1 | 0 | 0 | 1 | 1 | 0 | 1 | 0 | 0 | 1 | 0 |
| 0 | 0 | 0 | 1 | 0 | 0 | 0 | 0 | 1 | 0 | 0 | 0 | 1 | 0 | 1 | 1 | 1 | 0 | 0 | 1 | 0 | 1 |
| 0 | 0 | 0 | 0 | 1 | 0 | 0 | 1 | 0 | 0 | 0 | 0 | 0 | 1 | 0 | 0 | 1 | 1 | 1 | 0 | 1 | 1 |
| 0 | 0 | 0 | 0 | 0 | 1 | 1 | 0 | 0 | 0 | 1 | 1 | 1 | 1 | 0 | 0 | 0 | 0 | 1 | 1 | 0 | 0 |

## FIG.6

| C0 | C2 | C4 | D0 | D2 | D4 | D6 | D8 | D10 | D12 | D14 | C1 | C3 | C5 | D1 | D3 | D5 | D7 | D9 | D11 | D13 | D15 |
|----|----|----|----|----|----|----|----|-----|-----|-----|----|----|----|----|----|----|----|----|-----|-----|-----|
| 1 | 1 | 1 | 1 | 1 | 1 | 1 | 1 | 1 | 1 | 1 | 0 | 0 | 0 | 0 | 0 | 0 | 0 | 0 | 0 | 0 | 0 |
| 0 | 0 | 0 | 0 | 0 | 0 | 0 | 0 | 0 | 0 | 0 | 1 | 1 | 1 | 1 | 1 | 1 | 1 | 1 | 1 | 1 | 1 |
| 0 | 1 | 1 | 0 | 0 | 1 | 0 | 1 | 0 | 0 | 1 | 0 | 0 | 0 | 0 | 1 | 1 | 0 | 1 | 1 | 0 | 0 |
| 0 | 0 | 0 | 0 | 1 | 0 | 1 | 1 | 1 | 0 | 0 | 0 | 1 | 0 | 0 | 0 | 0 | 0 | 1 | 0 | 1 | 1 |
| 0 | 0 | 1 | 0 | 0 | 0 | 0 | 0 | 1 | 1 | 1 | 0 | 0 | 0 | 1 | 0 | 0 | 1 | 0 | 1 | 0 | 1 |
| 0 | 0 | 0 | 1 | 0 | 1 | 1 | 0 | 0 | 1 | 0 | 0 | 0 | 1 | 0 | 0 | 1 | 1 | 0 | 0 | 1 | 0 |

701 · 702 · 700

**FIG.7**

800 · 801

C0 C2,C4 | D0,D2,D4 ········ D14 — M1

802

C1 C3,C5 | D1,D3,D5 ········ D15 — M2

803

**FIG.8**

904 · t · 900 · 905

M1

SED — 901

902 · M2

SEC DED — 903

**FIG.9**

EP 2 394 366 B1

| C0 | C1 | C2 | C3 | C4 | C5 | D0 | D1 | D2 | D3 | D4 | D5 | D6 | D7 | D8 | D9 | D10 | D11 | D12 | D13 | D14 | D15 | |
|---|---|---|---|---|---|---|---|---|---|---|---|---|---|---|---|---|---|---|---|---|---|---|
| 1 | 0 | 0 | 1 | 0 | 0 | 1 | 0 | 0 | 1 | 0 | 0 | 1 | 0 | 0 | 1 | 0 | 0 | 1 | 0 | 0 | 1 | 1000 |
| 0 | 1 | 0 | 0 | 1 | 0 | 0 | 1 | 0 | 0 | 1 | 0 | 0 | 1 | 0 | 0 | 1 | 0 | 0 | 1 | 0 | 0 | |
| 0 | 0 | 1 | 0 | 0 | 1 | 0 | 0 | 1 | 0 | 0 | 1 | 0 | 0 | 1 | 0 | 0 | 1 | 0 | 0 | 1 | 0 | |
| 0 | 0 | 0 | 1 | 0 | 0 | 0 | 0 | 0 | 0 | 1 | 1 | 0 | 1 | 1 | 1 | 1 | 1 | 1 | 0 | 0 | 1 | |
| 0 | 0 | 0 | 0 | 1 | 0 | 0 | 0 | 1 | 1 | 0 | 0 | 1 | 0 | 1 | 1 | 1 | 0 | 0 | 1 | 1 | 1 | |
| 0 | 0 | 0 | 0 | 0 | 1 | 1 | 1 | 0 | 0 | 0 | 0 | 1 | 1 | 0 | 0 | 0 | 1 | 1 | 1 | 1 | 1 | |

FIG.10

| C0 | C1 | C2 | C3 | C4 | C5 | C6 | D0 | D1 | D2 | D3 | D4 | D5 | D6 | D7 | D8 | D9 | D10 | D11 | D12 | D13 | D14 | D15 | |
|---|---|---|---|---|---|---|---|---|---|---|---|---|---|---|---|---|---|---|---|---|---|---|---|
| 1 | 0 | 0 | 0 | 1 | 0 | 0 | 0 | 1 | 0 | 0 | 0 | 1 | 0 | 0 | 0 | 1 | 0 | 0 | 0 | 1 | 0 | 0 | 1100 |
| 0 | 1 | 0 | 0 | 0 | 1 | 0 | 0 | 0 | 1 | 0 | 0 | 0 | 1 | 0 | 0 | 0 | 1 | 0 | 0 | 0 | 1 | 0 | |
| 0 | 0 | 1 | 0 | 0 | 0 | 1 | 0 | 0 | 0 | 1 | 0 | 0 | 0 | 1 | 0 | 0 | 0 | 1 | 0 | 0 | 0 | 1 | |
| 0 | 0 | 0 | 1 | 0 | 0 | 0 | 1 | 0 | 0 | 0 | 1 | 0 | 0 | 0 | 1 | 0 | 0 | 0 | 1 | 0 | 0 | 0 | |
| 0 | 0 | 0 | 0 | 1 | 0 | 0 | 0 | 0 | 0 | 0 | 1 | 0 | 1 | 1 | 0 | 0 | 1 | 1 | 1 | 1 | 1 | 1 | |
| 0 | 0 | 0 | 0 | 0 | 1 | 0 | 0 | 0 | 0 | 1 | 0 | 1 | 0 | 0 | 1 | 1 | 1 | 0 | 0 | 0 | 0 | 1 | |
| 0 | 0 | 0 | 0 | 0 | 0 | 1 | 1 | 1 | 1 | 0 | 0 | 0 | 0 | 0 | 0 | 1 | 0 | 1 | 1 | 1 | 1 | 0 | |

FIG.11

EP 2 394 366 B1

```
                              ┌─────────────────┐    ╭─1201
                              │    RECEPTION    │
                              │  MOT DE CODE    │
                              └─────────────────┘
                                      │
                                      ▼
                              ┌─────────────────┐    ╭─1202
                              │   CALCUL DU     │
                              │   SYNDROME      │
                              └─────────────────┘
                                      │
                                      ▼
        ╭─1204                      ◇ 1203
   ┌──────────┐        OUI      ╱ SITUATION ╲
   │  CALCUL  │◄────────────── ╱      1      ╲
   │    DE    │                ╲      ?      ╱
   │   EM1    │                 ╲           ╱
   └──────────┘                   NON
        │                          │
        │              OUI        ◇ 1205
        │        ┌──────────── ╱ SITUATION ╲
        │        │             ╱      2      ╲
        │        ▼             ╲      ?      ╱
        │   ┌──────────┐        ╲           ╱
        │   │  CALCUL  │          NON
        │   │    DE    │           │
        │   │   EM2    │          ◇ 1207
        │   └──────────┘     ╱ SITUATION ╲    OUI      ╭─1208
        │     1206          ╱      3      ╲ ──────┐
        │                   ╲      ?      ╱       │  ┌──────────┐
        │                    ╲           ╱        ▼  │  CALCUL  │
        │                      NON                   │    DE    │
        │                       │                    │   EM3    │
        └───────────●───────────┼────────────────────└──────────┘
                                ▼
                        ┌─────────────────┐
                        │║               ║│
                        │║      FIN      ║│
                        │║               ║│
                        └─────────────────┘
```

# FIG.12

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1300952 A

**Littérature non-brevet citée dans la description**

- **P.K. LALA.** Self-Checking and Fault-Tolerant Design, San-Francisco. Morgan Kaufmann, 2001

- Error-correcting codes for semiconductor memory applications : a state of the art review. **C.L. CHEN ; M.Y. HSIAO.** Reliable Computer Systems - Design and Evaluation. Digital Press, 1992, 771-786